# EUROPÄISCHE PATENTSCHRIFT

(11) **EP 2 632 239 B1**
(45) Veröffentlichungstag und Bekanntmachung des Hinweises auf die Patenterteilung: **25.10.2017**
(21) Anmeldenummer: 12156567.5
(22) Anmeldetag: 22.02.2012
(51) Int. Cl.: H05K 7/14

(54) **Chirurgiegerät mit Gummi-Metall-Elementen zur Baugruppenbefestigung**
Surgical device with rubber-metal elements for fixing components
Appareil chirurgical doté d'éléments en caoutchouc et métal pour la fixation de composants

(43) Veröffentlichungstag der Anmeldung: 28.08.2013
(73) Patentinhaber: Erbe Elektromedizin GmbH, 72072 Tübingen (DE)
(72) Erfinder: Groß, Stefan, 72072 Tübingen (DE)
(74) Vertreter: Rüger, Barthelt & Abel

(56) Entgegenhaltungen:
- WO-A1-2009/096960
- DE-A1- 10 135 109
- US-A1- 2007 152 697
- US-A1- 2008 117 614
- US-A1- 2009 122 505

## Beschreibung

Die Erfindung betrifft ein Chirurgiegerät mit einem Gehäuse, in dem mindestens eine Baugruppe gelagert ist. Chirurgiegeräte sind typischerweise in kleineren, bedarfsweise flexibel zu gestaltenden Serien herzustellende Geräte, die in Gebrauch hohen Sicherheitsanforderungen genügen und robust ausgebildet sein müssen. Zum Test solcher Geräte gibt es verschiedene Vorschriften. Beispielsweise kann vorgesehen sein, dass ein solches Chirurgiegerät einen Fall aus einem Meter Höhe unbeschadet überstehen muss. Es können auch Schwingungsprüfungen vorgesehen sein, wonach das Chirurgiegerät Schwingungen vorgegebener Amplitude z.B. im Frequenzbereich von 2 bis 5,5 Hz unbeschadet aushalten muss. Dabei müssen Baugruppen eines solchen Chirurgiegeräts unbeschädigt bleiben und dürfen sich in dem Gerätegehäuse nicht lösen. Solche Baugruppen können eine relativ große Masse von bspw. mehreren hundert Gramm bis zu mehreren Kilogramm aufweisen. Derartige Baugruppen sind bspw. Ventilblöcke, Pumpen, Transformatoren oder Ähnliches.

Aus der US 2009/0122505 A1 ist die Befestigung von Leiterplatten in elektrischen Geräten mittels stoßabsorbierender elastischer Elemente bekannt. Diese elastischen Elemente bestehen bspw. aus Gummi und weisen ausgehend von einem hohlzylindrischen Grundkörper an ihrem Außenumfang eine halbrunde Nut auf, die zur Aufnahme der Leiterplatte dient. Die Leiterplatte weist C-förmige Randausnehmungen auf, in denen die stoßabsorbierenden Elemente sitzen. Die Randausnehmungen sind paarweise an zueinander parallelen voneinander weg weisenden Kanten der Leiterplatte angeordnet. Die stoßabsorbierenden Elemente sind von Schrauben durchgriffen, die mit entsprechenden Gewindesockeln des Gehäuses verschraubt sind.

Die Montage oder Demontage einer Baugruppe erfordert hier das Einschrauben bzw. Lösen der Befestigungsschrauben, die durch die stoßabsorbierenden Elemente gehen.

Die DE 101 35 109 A offenbart eine Sensoranordnung, die auf einen Träger angeordnet ist, der Träger weist vier Löcher auf, in denen Gummipuffer sitzen. Jeder Gummipuffer weist ausgehend von einer hohlzylindrischen Grundform und seinem Außenumfang eine Rechtecknut auf. Die Gummipuffer sind in die entsprechenden Öffnungen des Trägers eingesetzt und werden ihrerseits von stiftartigen Abstandshaltern getragen. Die Stifte sind in einem zweiten Träger eingesetzt und an diesem befestigt.

Zur Justage der Position der Sensoranordnung können die Stifte unterschiedlich weit in den zweiten Träger eingeschoben werden. Außerdem können sie durch Schrauben ersetzt werden.

Weitere Anordnungen zur stoßgedämpften Befestigung von Baugruppen offenbaren die US 2008/0117614 A1 und die WO 2009/096960 A1. Bei diesen Vorschlägen wird davon ausgegangen, dass die zu befestigende Baugruppe Rundöffnungen aufweist, in denen Gummielemente sitzen, die ihrerseits von Befestigungsbolzen durchgriffen sind.

Die US 2007/0152697 A1 offenbart außerdem die Befestigung einer Leiterplatte mittels einer Metallrastfeder, die auf die Leiterplatte aufgebracht ist und mit einem Rasthaken wechselwirkt.

Die Befestigung größerer Baugruppen in Chirurgiegeräten unterliegt den eingangs geschilderten hohen Anforderungen, wobei andererseits eine flexible Produktion möglich sein soll.

Es ist Aufgabe der Erfindung, ein Konzept zu schaffen, mit dem in einem Chirurgiegerät solche Baugruppen unter Beachtung wenigstens einer der obigen Randbedingungen gelagert sind.

Diese Aufgabe wird mit einem Chirurgiegerät nach Anspruch 1 gelöst:
Das erfindungsgemäße Chirurgiegerät weist ein Gehäuse auf, das mindestens eine Baugruppe umschließt. Bei dieser Baugruppe kann es sich insbesondere um eine Baugruppe mit erheblichem Eigengewicht von bspw. mehr als einem halben Kilogramm, bspw. 1,5 Kg oder mehr handeln. Zur Befestigung der Baugruppe in dem Gehäuse sind Rastfüße vorgesehen, wobei mindestens einer der Rastfüße anspruchsgemäß ausgebildet ist und einen elastischen Körper aufweist. Dieser Körper besteht vorzugsweise aus einem Elastomermaterial mit gummielastischen Eigenschaften. Er ist vorzugsweise rotationssymmetrisch ausgebildet, so dass er einen Kreisquerschnitt aufweist. An seiner Oberseite und seiner Unterseite ist er durch eine Metallscheibe abgeschlossen. Diese Metallscheibe ist vorzugsweise eine ebene Scheibe oder Platte. Vorzugsweise bilden die Scheiben und der Elastomerkörper eine bauliche Einheit. Sie sind stoffschlüssig miteinander verbunden, z.B. vulkanisiert. Der Rastfuß sitzt in einer entsprechenden Rastöffnung, in die er durch eine Bewegung quer zu seiner Mittelachse eingerastet werden kann, womit die Verbindung zwischen dem Gehäuse und der Baugruppe hergestellt wird. Die Scheiben stabilisieren den elastischen Köper des Rastfußes und bewirken, dass Axialkräfte nicht zum Herausziehen des Rastfußes aus seiner Rastöffnung führen können.

Die Verbindung ist schwingungs- und vibrationsdämpfend. Dämpfungseigenschaften des elastischen Körpers können dazu genutzt werden, die Körperschallübertragung zu minimieren.

Vorzugsweise bilden die beiden Scheiben mit einem dazwischen angeordneten Steg einen Metallkörper, der vorzugsweise rotationssymmetrisch ausgebildet ist. Der die beiden Scheiben verbindende Steg gibt dem Elastomerkörper zusätzliche Stabilität, um dauernden schwingenden Belastungen und Stoßbelastungen, wie sie bei Falltests auftreten können, Stand zu halten.

Es ist möglich, einen oder mehrere Rastfüße an der Baugruppe anzuordnen und die Rastöffnungen in dem Gehäuse oder einem Teil desselben auszubilden. Das Gehäuse kann dazu einen gesonderten Träger aufweisen, der im Abstand zu einer Gehäusewand in dem von dem Gehäuse umschlossenen Innenraum angeordnet ist. Es ist auch möglich, die Rastfüße an der Gehäusewand oder dem Träger anzuordnen und die Rastöffnungen in der Baueinheit auszubilden. Es sind auch gemischte Bauformen möglich, bei denen Rastfüße sowohl an dem Gehäuse bzw. dem Träger als auch an der Baugruppe vorgesehen sind.

Der Träger ist vorzugsweise durch eine Trägerplatte gebildet, die wenigstens einen ebenen Abschnitt zur Aufnahme der Baugruppe aufweist. Die Trägerplatte kann mit dem übrigen Gehäuse auf jede geeignete Weise verbunden sein.

Der Elastomerkörper und die Scheiben und/oder der Steg sind vorzugsweise stoffschlüssig miteinander verbunden. Es ist jedoch auch möglich, den Elastomerkörper auf dem Metallkörper lediglich formschlüssig zu sichern.

Die Scheiben und der Steg sind vorzugsweise aus Metall, beispielsweise Aluminium oder Stahl ausgebildet. Alternative Bauformen mit Scheiben und/oder Steg aus Kunststoff sind ebenfalls möglich.

Die Scheiben und der Steg gehen vorzugsweise einteilig ineinander über. Es ergeben sich ein einfacher Aufbau und eine robuste Gestaltung.

Die Scheiben sind vorzugsweise kreisrund und zueinander konzentrisch ausgebildet. Damit können die Rastfüße als Schraubfüße ausgebildet werden. Ihre Drehposition spielt für ihre spätere Funktion keine Rolle.

Vorzugsweise weisen die beiden Scheiben unterschiedliche Durchmesser auf. Damit vereinfacht sich die Montage der Baugruppe. Beim Einsetzen der Rastfüße in die Rastöffnungen findet jeder Rastfuß automatisch die Axialposition, in der er dann durch eine entsprechende Bewegung der Baugruppe in Montageposition eingerastet werden kann. Die Rastfüße halten die Baugruppe in einem Abstand zu dem Träger.

Der elastische Körper schließt vorzugsweise an seinem Außenumfang bündig mit.den Scheiben ab. Dadurch wird eine gute axiale Unterstützung des elastischen Körpers erreicht, die zu einer besonderen Stoßfestigkeit der mit den Rastfüßen erzeugten Rastverbindung führt. Die Scheiben untergrei-fen den Rand der Rastöffnung. Bezüglich axialer Kräfte ist eine Formschlussverbindung gegeben. Es besteht aber kein Metall/Metall-Kontakt. Zwischen dem Metallkörper des Rastfußes und dem Träger ist der elastische Körper angeordnet.

Die den Rastfüßen zugeordneten Rastausnehmungen weisen jeweils einen Halteabschnitt auf, dessen Durchmesser geringer ist als die Durchmesser der beiden Scheiben. Der Rand der Rastausnehmung erstreckt sich über einen Winkel von mehr als 180°, vorzugsweise 235°. Der Rand der Rastausnehmung kann bei entsprechenden Gegebenheiten einen Winkel bis zu 280° einnehmen. Der Durchmesser der Rastausnehmung entspricht vorzugsweise dem Durchmesser des Bodens der in dem Elastomerkörper ausgebildeten Nut. Der Rand des Halteabschnitts führt zu einem Eingang der Rastausnehmung, bei dem sich gerundete Vorsprünge gegenüber stehen. Die Rundungsradien der beiden Vorsprünge stimmen miteinander vorzugsweise überein. Vorzugsweise verhält sich der Rundungsradius des Vorsprungs zu dem Durchmesser des Bodens der Nut wie 1/2. Außerdem wird es als vorteilhaft angesehen, wenn sich der Durchmesser des Bodens der Nut zu dem Durchmesser des Stegs wie 4/1 bis 2/1 insbesondere 2,75/1 verhält. Zwischen den Vorsprüngen ist ein Abstand festgelegt, der geringer ist als der Durchmesser des Bodens der Nut, jedoch größer als der Durchmesser des eventuell vorhandenen Stegs des Metallkörpers. Der Abstand zwischen den Vorsprüngen am Eingang der Rastausnehmung verhält sich in etwa wie 2/1 zu dem Durchmesser des Steges, vorzugsweise wie 2,125/1. Damit wird einerseits ein leichtes Einrasten und andererseits ein sicheres Halten der Rastfüße ermöglicht. Desweiteren weist die Rastausnehmung einen Einführabschnitt auf, der größer ist als wenigstens eine der Scheiben. Dadurch kann der Rastfuß axial in die Rastausnehmung eingeführt werden.

Bei einer bevorzugten Ausführungsform ist bei jeder Rastöffnung der Halteabschnitt und der Rastabschnitt in übereinstimmendem Radialabstand zu einem Drehpunkt der Baugruppe angeordnet. Der Drehpunkt der Baugruppe ist derjenige Drehpunkt, um den die Baugruppe zu drehen ist, um sie in oder außer Eingriff mit dem Träger zu bringen. Dabei können alle Rastausnehmungen auf einem einheitlichen Radius oder auch auf unterschiedlichen Radien angeordnet sein. Die verschiedenen Rastausnehmungen sind jedoch in Umfangsrichtung in gleicher Drehrichtung orientiert.

Weitere Einzelheiten vorteilhafter Ausführungsformen der Erfindung sind Gegenstand der Zeichnung, von Ansprüchen oder der Beschreibung. Es zeigen:
Figur 1 ein Chirurgiegerät in schematisierter, teilweise aufgebrochener Darstellung,
Figur 2 einen ausschnittsweisen schematisierten Vertikalschnitt durch das Chirurgiegerät nach Figur 1,
Figur 3 einen Rastfuß zur Verbindung einer Baugruppe mit einem Träger, in teilweiser Vertikalschnittdarstellung,
Figur 4 den Rastfuß nach Figur 3, in ausschnittsweiser Seitenansicht,
Figur 5 den Rastfuß in Verbindung mit einem Träger, in teilweise geschnittener Seitenansicht,
Figur 6 einen Träger mit Rastöffnungen zur Aufnahme der Rastfüße, in Draufsicht,
Figur 7 eine Rastöffnung in gesonderter Darstellung,
Figur 8 bis 10 Ausführungsformen von Rastfüßen und mit ihnen erzeugten Verbindungen, jeweils in wenigstens teilweise geschnittener Seitenansicht.
Figur 11 eine Baugruppe mit nur einem Rastfuß und ein Träger dazu.

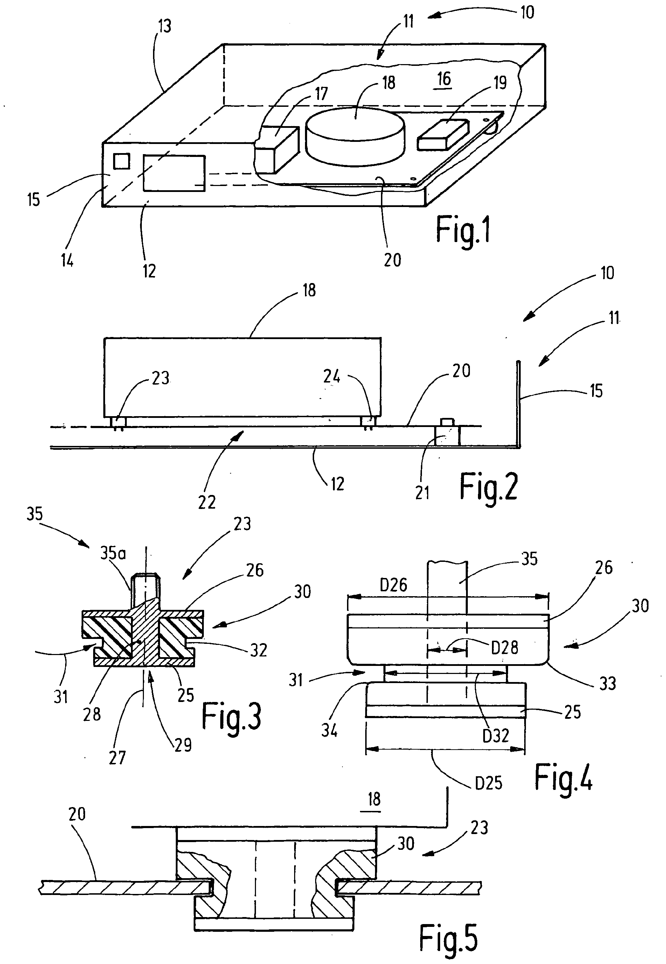

In Figur 1 ist ein Chirurgiegerät 10 veranschaulicht, das ein Gehäuse 11 mit einem Boden 12, eine Haube 13, eine Frontfläche 14 und Seitenflächen 15 aufweist. Das Gehäuse 11 umschließt einen Innenraum 16, in dem mindestens eine, vorzugsweise mehrere Baugruppen 17, 18, 19 unterschiedlicher Größe und Art angeordnet sind. Die in Figur 1 veranschaulichte Baugruppe 18 stellt im vorliegenden Beispiel eine besonders schwergewichtige Baugruppe, wie bspw. eine Pumpe, einen Ventilblock, einen Transformator oder dergleichen dar. Sie kann deutlich mehr als 500g, bspw. 1 kg oder 1,5 kg oder mehr wiegen.

Die Baugruppen 17 bis 19 sind in dem Gehäuse 11 auf einem Träger 20 angeordnet. Dieser kann an dem Boden 12 oder auch an den Seitenwänden 15 oder einer sonstigen nicht weiter veranschaulichten inneren Struktur des Gehäuses 11 gehalten sein. Im vorliegenden Ausführungsbeispiel ist der Träger 20 durch mehrere Abstandshalter 21 in Distanz zu dem Boden 12 gehalten. Der Träger 20 kann eine ebene Platte oder ein räumlich anderweitig geformtes Teil mit einem vorzugsweise ebenen Aufnahmeabschnitt 22 sein, auf dem die Baugruppe 19 platziert ist.

Die Baugruppe 18 ist an dem Träger 20 vorzugsweise ausschließlich durch Rastfüße 23, 24 gehalten, die einerseits fest mit der Baugruppe 18 verbunden und andererseits mit dem Träger 20 verrastet sind. Die Anzahl der Rastfüße 23, 24 richtet sich nach den Ansprüchen des Einzelfalls. Zum Beispiel können ein, zwei, drei, vier oder auch mehr Rastfüße Anwendung finden.

Figur 3 und 4 veranschaulichen den Rastfuß 23 stellvertretend für weitere vorhandene Rastfüße. Der Rastfuß 23 ist ein vorzugsweise rotationssymmetrisches Elastomer-Metall-Element. Es weist eine erste Scheibe 25 und eine zweite Scheibe 26 mit einem Durchmesser D26 auf, die jeweils vorzugsweise einen kreisförmigen Umriss haben. Wenn gewünscht, kann die Scheibe 26 und/oder die Scheibe 25 auch einen abweichenden Umriss aufweisen, z.B. rechteckig oder anderweitig ausgebildet sein. Sie sind parallel zueinander jeweils konzentrisch zu einer Mittelachse 27 angeordnet. Die beiden Scheiben 25, 26 sind durch einen vorzugsweise kreiszylindrischen Steg 28 untereinander verbunden, der ebenfalls konzentrisch zu der Mittelachse 27 angeordnet ist. Die Scheiben 25, 26 und der Steg 28 bilden vorzugsweise einen nahtlos einteiligen Körper 29.

Die beiden Scheiben 25, 26 können gleiche Durchmesser aufweisen. Bei dem Ausführungsbeispiel nach Figur 2 weist die untere Scheibe 25, d.h. die von der Baugruppe 18 weg liegende Scheibe 25, einen geringeren Durchmesser D25 auf, als die Scheibe 26. Zwischen den Scheiben 25, 26 ist ein elastischer Körper 30 angeordnet, der bspw. aus Gummi oder einem Elastomer, z.B. EPM, EPDM, FPM oder dergleichen besteht. Der Körper 30 haftet vorzugsweise an der Scheibe 26, der Scheibe 25, wie auch an dem Steg 28. Um dies zu erzielen, wird das Grundmaterial des Körpers 30 vorzugsweise in formbarem Zustand zwischen die Scheiben 25, 26 und um den Steg 28 herum angeordnet und dann vernetzt (ausgehärtet). Der Vernetzungsprozess kann bspw. ein Vulkanisierprozess sein, bei dem sich auch ein Verbund zwischen dem elastischen Körper 30 und der Oberfläche der Scheiben 25, 26 und des Stegs 28 herstellt.

Der elastische Körper 30 schließt vorzugsweise stufen- und übergangslos und somit glatt an den äußeren Rand der Scheibe 26 an. Der elastische Körper 30 schließt vorzugsweise ebenso glatt und stufenlos und somit absatzlos an den äußeren Rand der Scheibe 25 an. Zwischen den sich dort jeweils ergebenden z.B. zylindrischen Bereichen des elastischen Körpers 30 ist eine Nut 31 ausgebildet, deren Boden 32 wiederum konzentrisch zu der Mittelachse 27 angeordnet ist und vorzugsweise einer Zylinderfläche folgt.

Die Übergänge von den Nutflanken zu den äußeren zylindrischen Partien des elastischen Körpers 30 können durch scharfe Kanten oder wie Figur 4 zeigt durch Rundungen 33, 34 gebildet sein.

An der größeren der beiden Scheiben 25, 26, ist ein Verbindungsmitttel 35 vorgesehen, um den Rastfuß 23 mit einem anderen Gegenstand, wie bspw. dem Träger 20 oder, wie aus Figur 2 hervorgeht, der Baugruppe 18 zu befestigen. Dieses Verbindungsmittel 35 kann durch einen Gewindezapfen 35a gebildet sein, der vorzugsweise konzentrisch zu der Mittelachse 27 angeordnet ist. Andere Verbindungs- bzw. Befestigungsmittel sind möglich.

Der Rastfuß 23 wird mit dem Träger 20 bei einer entsprechenden Ausnehmung 36 verbunden. Figur 5 zeigt einen Vertikalschnitt durch den Träger 20 und den Rastfuß 23, wenn beide zusammengefügt sind. Wie ersichtlich, ist der Rastfuß 23 in axialer, in Figur 5 vertikaler Richtung sicher an den Träger 20 gehalten. Der Träger 20 ist sowohl oben wie auch unten von dem elastischen Körper 30 übergriffen. Es besteht keine direkte Metall/MetallVerbindung. Der elastische Körper 30 überträgt die nötigen Haltekräfte zwischen der Baugruppe 18 und dem Träger 20, wobei er jedoch schwingungsdämpfend wirkt..

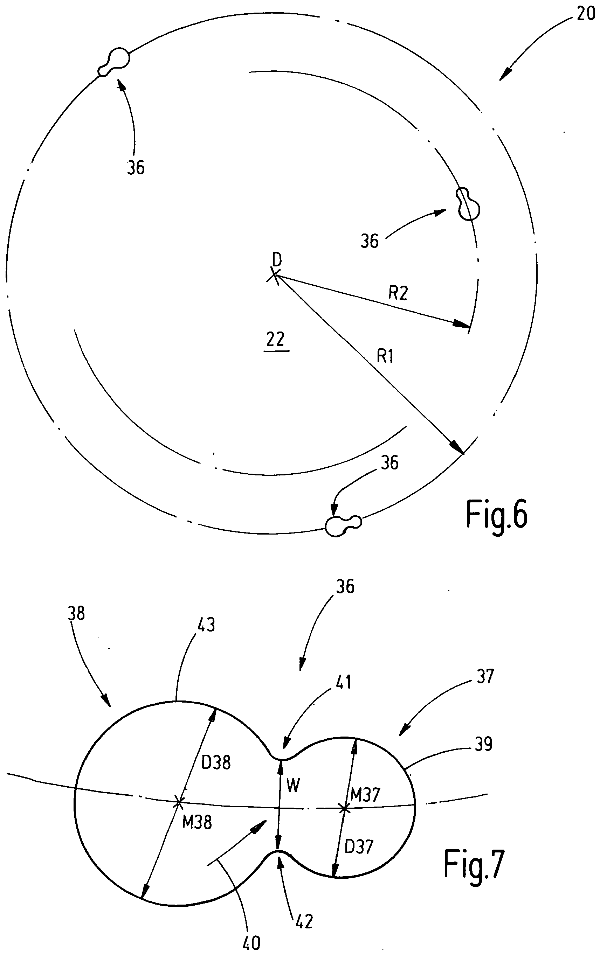

Figur 6 veranschaulicht den Träger 20 bzw. dessen Aufnahmeabschnitt 22. Dieser ist im vorliegenden Ausführungsbeispiel mit insgesamt drei Rastausnehmungen 36 versehen, die untereinander im Wesentlichen gleich ausgebildet sind. Dies gilt zumindest für Rastausnehmungen 36, die auf gleichen oder ähnlichen Radien R1, R2 bezüglich eines Drehpunkts D angeordnet sind. Ähnlich sind die Radien R1, R2 dann, wenn der Winkelbetrag einer zum Ein- und Ausrasten der Baugruppe 18 erforderlichen Drehung bei den verschiedenen Radien R1 und R2 einen Wegunterschied in Umfangsrichtung ergibt, der im Rahmen der Fügetoleranz von Rastfuß und Rastausnehmung liegt. Sind die Radien R1, R2 um einen größeren Betrag verschieden werden für den kleineren Radius R2 entsprechend kleinere Rastausnehmungen und Rastfüße vorgesehen als für den größeren Radius R1.

Figur 7 veranschaulicht den prinzipiellen Aufbau einer Rastausnehmung 36. Die Rastausnehmung 36 besteht aus einem Halteabschnitt 37 und einem Einführabschnitt 38. Durch die geometrische Gestaltung des Halteabschnitts 37 und des Einführabschnitts 38 in Verbindung mit deren Positionierung zueinander entsteht eine ungefähr 8-förmige Kontur. Der Halteabschnitt 37 weist einen Durchmesser D37 auf, der im Wesentlichen so groß ist wie der Durchmesser D32 des Bodens 32 der Nut 31 (siehe Figur 4). Der Halteabschnitt 37 weist einen Rand 39 auf, der um den Mittelpunkt M37 des Halteabschnitts 37 um einen Winkel vom mehr als 180° herum führt. Der insgesamt C-förmige Rand 39 führt somit zu einem Eingang 40, bei dem sich zwei gerundete Vorsprünge 41, 42 gegenüber stehen. Der Abstand der beiden Vorsprünge 41, 42 definiert die Weite W des Eingangs 40. Diese ist größer als der Durchmesser D28 des Stegs 28. die Weite W ist jedoch kleiner als der Durchmesser D37. Die Differenz des Durchmessers D37 und der Weite W ist so bemessen, dass sie durch elastische schädigungslose Verformung des elastischen Körpers 30 überwunden werden kann.

Der Einführabschnitt 38 schließt sich mit einem wiederum C-förmigen Rand 43 an die Vorsprünge 41, 42 an. Dieser Rand 43 folgt vorzugsweise einem Kreisbogen mit einem Durchmesser D38. Dieser Durchmesser ist vorzugsweise spürbar größer als der Durchmesser D25 der Scheibe 25.

Der Mittelpunkt M38 und der Mittelpunkt M37 sind von dem Drehpunkt D vorzugsweise gleich weit entfernt. Es wird darauf hingewiesen, dass der Einführabschnitt 38 bei jeder der beschriebenen oder sich ergebenden Ausführungsformen von der vorgestellten Kreisform abweichen kann solange er einen ausreichenden Durchgang für die kreisförmige oder nichtkreisförmige Scheibe 25 bietet.

Zum Befestigen der Baugruppe 18 auf dem Träger 20 wird die Baugruppe 18 mit den in entsprechenden Positionen angebrachten Rastfüßen 23, 24 (und weiteren) voran so auf den Träger 20 zu bewegt, dass die jeweiligen Scheiben 25 der Rastfüße durch die jeweiligen Einführabschnitte 38 der Rastausnehmungen 36 finden. Wie Figur 5 erkennen lässt, steht dabei der obere Teil des elastischen Körpers 30 auf der Oberseite des Trägers 20 auf. Sind die Rastfüße derart positioniert wird nun die Baugruppe 28 so gedreht, dass die Rastfüße aus den Einführabschnitten 36 in die Halteabschnitte 37 wechseln. Dabei muss der elastische Körper 30 durch den Eingang 40 in den Halteabschnitt 37 bewegt werden. Der Körper 30 wird dabei zwischen den Vorsprüngen 41, 42 elastisch zusammengedrückt. Die Rundungen der Vorsprünge 41, 42 sind dabei so bemessen, dass keine Schädigung des elastischen Körpers 30 auftritt und dass sich dieser nicht von den Scheiben 25, 26 löst.

Ist die Rastverbindung hergestellt, ist die Baugruppe 18 sicher an den Träger 20 gehalten. Nur eine Drehung in Gegenrichtung kann eine Lösung der Verbindung bewirken. Weder beim Vibrationstest noch beim Falltest werden Kräfte erwartet, die eine Drehung bewirken, die zur Lösung der Rastverbindung führen kann.

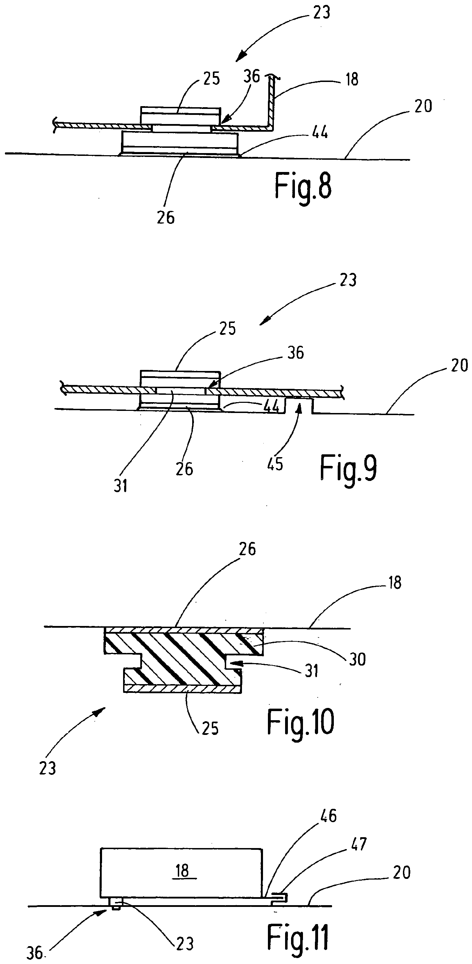

Die Figuren 8 bis 10 veranschaulichen abgewandelte Ausführungsformen für die die vorige Beschreibung entsprechend gilt. Ergänzend wird darauf hingewiesen, dass anstelle des Gewindezapfens 35a andere Verbindungsmittel vorgesehen werden können. Beispielswiese kann der Rastfuß 23 mit einem Teil verbunden sein indem die große Scheibe 26 über Schweißpunkte oder -nähte 44 an diesem Teil stoffschlüssig befestigt ist. Dieses Teil kann die Baugruppe 18 oder wie in Figur 8 veranschaulicht auch der Träger 20 sein. Im letzteren Fall ist die Rastöffnung 36 dann in der Baugruppe 18 untergebracht. Die Scheibe 25 mit dem kleineren Durchmesser ist auf der von dem Träger 20 weg liegenden Seite des Rastfußes 23 angeordnet.

Figur 9 veranschaulicht, dass beide Scheiben 25, 26 auch einheitliche Durchmesser aufweisen können. Dies gilt als Alternative bei allen Ausführungsformen. Allerdings ist hier keine automatische Positionierung der Rastausnehmung 36 auf Höhe der Nut 31 gegeben. Eine solche Distanzierung oder Nivellierung kann durch andere Mittel bewirkt werden. Zur vereinfachten Montage des Rastfuß 23 bspw. auf dem Träger 20, wie es Figur 9 nahelegt, können an dem Träger 20 gesonderte Vorsprünge in Form von Abstandshalter 45, bspw. in Gestalt von Zapfen, Noppen, Rippen oder dergleichen vorgesehen sein.

Eine weitere Abwandlung des erfindungsgemäßen Rastfußes zeigt Figur 10 als Rastfuß 23'. Dieser kommt ohne Steg 28 aus. Ansonsten gilt die vorige Beschreibung in jeder Hinsicht und jeder Variante entsprechend. Die Scheibe 25 steift den Körper 30 so aus, dass der Rastfuß nicht axial aus dem Halteabschnitt 37 einer Rastöffnung 36 gezogen werden kann.

Figur 11 veranschaulicht eine gemischte Befestigung der Baugruppe 18 auf dem Träger 20. Es sind nur mindestens ein Rastfuß 23 und mindestens eine Rastöffnung vorgesehen, die durch eine lineare Bewegung der Baugruppe 18 gegen den Träger 20 in Eingriff zu bringen sind. Eine oder mehrere sich etwa parallel zu dem Träger 20 erstreckende Laschen 46 fassen in eine oder mehrere Öffnungen 47, die in einem zu dem Träger 20 ortsfesten Halter angeordnet sind und sich den Laschen 47 entgegen öffnen.

Das erfindungsgemäße Chirurgiegerät 10 weist zur Verbindung einer Baugruppe 18 mit dem Gehäuse 11 Rastfüße 23 auf, denen Rastausnehmungen 36, zum Beispiel in einem zu dem Gehäuse 11 gehörigen Träger 20 zugeordnet sind. Die Rastfüße 23 sind vorzugsweise als Gummi-Metall-Elemente ausgebildet, mit einer Ringnut, die durch die Taille (Eingang 40) einer im Wesentlichen 8-förmigen Öffnung mit zwei unterschiedlich großen Abschnitten 37, 38 passt. Die Rastausnehmungen 36 sind auf einem oder mehreren Kreisen angeordnet, wobei die 8-förmigen Rastausnehmungen in gleicher Richtungsorientierung längs dieser Kreise liegen. Das Einrasten der Baugruppe 18 erfolgt somit durch eine Drehung der Baugruppe um einige Grad.

### Bezugszeichenliste:

- 10: Chirurgiegerät
- 11: Gehäuse
- 12: Boden
- 13: Haube
- 14: Frontfläche
- 15: Seitenflächen
- 16: Innenraum
- 17 19: Baugruppen
- 20: Träger
- 21: Abstandshalter
- 22: Aufnahmeabschnitt
- 23, 24: Rastfüße (23')
- 25: erste Scheibe
- 26: zweite Scheibe
- 27: Mittelachse
- 28: Steg
- 29: Körper
- 30: elastischer Körper
- 31: Nut
- 32: Boden
- 33, 34: Rundungen
- 35: Verbindungsmittel
- 35a: Gewindezapfen
- 36: Rastausnehmungen/Rastöffnung
- R1: größerer Radius
- R2: kleinerer Radius
- D: Drehpunkt
- 37: Halteabschnitt
- 38: Einführabschnitt
- D37: Durchmesser des Halteabschnitts 37
- D32: Durchmesser des Bodens 32 der Nut 31
- 39: Rand des Halteabschnitts 37
- M37: Mittelpunkt
- 40: Eingang
- 41, 42: Vorsprünge, die den Eingang 40 begrenzen
- D28: Durchmesser des Stegs 28
- W: Weite des Eingangs 40
- 43: Rand des Einführabschnitts 38
- D38: Durchmesser des Einführabschnitts 38
- D25: Durchmesser der Scheibe 25
- M38: Mittelpunkt des Einführabschnitts 38
- 44: Naht
- 45: Abstandshalter
- 46: Laschen
- 47: Öffnungen

## Patentansprüche

1. Chirurgiegerät (10)
mit einem Gehäuse (11), das mindestens eine Baugruppe (18) umschließt,
mit einem Träger (20), der Rastöffnungen (36) aufweist und auf dem die Baugruppe (18) angeordnet ist,
mit wenigstens einem Rastfuß (23) zur Befestigung der Baugruppe (18) in dem Gehäuse (11),
wobei der Rastfuß (23) zwei Scheiben (25, 26) und einen elastischen Körper (30) umfasst, der zwischen den Scheiben (25, 26) angeordnet ist, wobei der elastische Körper (30) an seinem Umfang eine Nut (31) aufweist,
wobei der Rastfuß (23) einer Rastöffnung (36) zugeordnet ist, die einen Halteabschnitt (37) und einen Einführabschnitt (38) aufweist, der Durchmesser des Halteabschnitts (D37) geringer ist, als die Durchmesser (D25, D26) der beiden Scheiben (25, 26) und wobei der Rand (39) des Halteabschnitts (37) sich entlang eines Bogens von mehr als 180° erstreckt, wobei die Rastöffnungen (36) in einem radialen Abstand (R1, R2) zu einem Drehpunkt (D) angeordnet und in gleicher Drehrichtung orientiert sind, wobei bei jeder Rastöffnung (36) der Mittelpunkt (M37) des Halteabschnitts (37) und der Mittelpunkt (M38) des Einführabschnitts (38) in übereinstimmendem Radialabstand (R1, R2) zu dem Drehpunkt (D) angeordnet sind.

2. Chirurgiegerät nach Anspruch 1, **dadurch gekennzeichnet, dass** die beiden Scheiben (25, 26) durch einen zu ihnen konzentrisch angeordneten Steg (28) miteinander verbunden sind und einen Körper (29) bilden.

3. Chirurgiegerät nach einem der vorhergehenden Ansprüche, **dadurch gekennzeichnet, dass** das Gehäuse (11) mindestens einen Träger (20) aufweist, der in einem Innenraum (16) des Gehäuse (11) angeordnet und in einem Abstand zu dem Boden (12) gehalten ist.

4. Chirurgiegerät nach Anspruch 3, **dadurch gekennzeichnet, dass** der Träger (20) durch eine Trägerplatte gebildet ist.

5. Chirurgiegerät nach einem der vorhergehenden Ansprüche, **dadurch gekennzeichnet, dass** der elastische Körper (30) mit den Scheiben (25, 26) und/oder dem Steg (28) stoffschlüssig verbunden ist.

6. Chirurgiegerät nach einem der vorhergehenden Ansprüche, **dadurch gekennzeichnet, dass** die Scheiben (25, 26) und/oder der Steg (28) aus Metall ausgebildet sind.

7. Chirurgiegerät nach einem der vorhergehenden Ansprüche, **dadurch gekennzeichnet, dass** die Scheiben (25, 26) und der Steg (28) nahtlos einteilig und aus einem einheitlichen Material ausgebildet sind.

8. Chirurgiegerät nach einem der vorhergehenden Ansprüche, **dadurch gekennzeichnet, dass** die Scheiben (25, 26) zueinander konzentrisch angeordnet sowie parallel zueinander orientiert sind.

9. Chirurgiegerät nach einem der vorhergehenden Ansprüche, **dadurch gekennzeichnet, dass** die beiden Scheiben (25, 26) unterschiedliche Durchmesser (D25, D26) aufweisen.

10. Chirurgiegerät nach einem der vorhergehenden Ansprüche, **dadurch gekennzeichnet, dass** der elastische Körper (30) an seinem Außenumfang mit den Scheiben (25, 26) bündig abschließt.

11. Chirurgiegerät nach Anspruch 1, **dadurch gekennzeichnet, dass** der Durchmesser (D37) des Halteabschnitts (37) dem Durchmesser (D32) des Bodens (32) der Nut (31) entspricht.

12. Chirurgiegerät nach Anspruch 1, **dadurch gekennzeichnet, dass** der Halteabschnitt (37) einen Eingang (40) aufweist, an dem sich gerundete Vorsprünge (41, 42) gegenüberstehen und zwischen einander einen Abstand (W) festlegen, der geringer ist als der Durchmesser (D32) des Bodens (32) der Nut (31), jedoch größer als der Durchmesser des Stegs (28).

13. Chirurgiegerät nach Anspruch 1, **dadurch gekennzeichnet, dass** die Rastausnehmung (36) einen Einführungsabschnitt (38) aufweist, der größer als wenigstens eine der Scheiben (25, 26) ist.

## Claims

1. Surgical device (10),
with a housing (11) which encloses at least one assembly (18),
with a carrier (20) which has detent openings (36) and on which the assembly (18) is arranged,
with at least one detent foot (23) for fixing the assemble (18) in the housing (11), wherein the detent foot (23) comprises two discs (25, 26) and an elastic body (30) which is arranged between the discs (25, 26), wherein the elastic body (30) comprises a groove (31) on its periphery,
wherein the detent foot (23) is assigned to a detent openings (36) which has a holding portion (37) and an insert portion (38), the diameter (D37) of the holding portion is smaller than the diameter (D25, D26) of the two discs (25, 26), and wherein the edge (39) of the holding portion (37) extends along an arc of more than 180°,
wherein the detent openings (36) are arranged at a radial distance (R1, R2) from a pivot point (D) and are oriented in the same direction of rotation, wherein for each detent opening (36), the centre point (M37) of the holding portion (37) and the centre point (M38) of the insert portion (38) arc arranged at the corresponding rotary distance (R1, R2) from the pivot point (D).

2. Surgical device according to claim 1, **characterised in that** the two discs (25, 26) are connected together by a web (28) arranged concentrically thereto and form one body (29).

3. Surgical device according to any of the preceding claims, **characterised in that** the housing (11) has at least one carrier (20) which is arranged in an interior (16) of the housing (11) and held at a distance from the floor (12).

4. Surgical device according to claim 3, **characterised in that** the carrier (20) is formed by a carrier plate.

5. Surgical device according to any of the preceding claims, **characterised in that** the elastic body (30) is connected by substance bonding to the discs (25, 26) and/or the web (28).

6. Surgical device according to any of the preceding claims, **characterised in that** the discs (25, 26) and/or the web (28) are made of metal.

7. Surgical device according to any of the preceding claims, **characterised in that** the discs (25, 26) and the web (28) are formed seamlessly of one piece and from a uniform material.

8. Surgical device according to any of the preceding claims, **characterised in that** the discs (25, 26) are arranged concentrically to each other and oriented parallel to each other.

9. Surgical device according to any of the preceding claims, **characterised in that** the two discs (25, 26) have different diameters (D25, D26).

10. Surgical device according to any of the preceding claims, **characterised in that** on its outer periphery, the elastic body (30) terminates flush with the discs (25, 26).

11. Surgical device according to claim 1, **characterised in that** the diameter (D37) of the holding portion (37) corresponds to the diameter (D32) of the base (32) of the groove (31).

12. Surgical device according to claim 1, **characterised in that** the holding portion (37) has an inlet (40), at which rounded protrusions (41, 42) stand opposite each other and establish between them a distance (W) which is smaller than the diameter (D32) of the base (32) of the groove (31) but larger than the diameter of the web (28).

13. Surgical device according to claim 1, **characterised in that** the detent recess (36) has an insert portion (38) which is larger than at least one of the discs (25, 26).

## Revendications

1. Appareil chirurgical (10)
comprenant un boîtier (11) qui entoure au moins un composant (18), comprenant un support (20) qui présente des ouvertures d'encliquetage (36) et sur lequel est disposé le composant (18),
comprenant au moins un talon d'encliquetage (23) destiné à la Fixation du composant (18) dans le boîtier (11),
sachant que le talon d'encliquetage (23) comporte deux disques (25, 26) et un corps (30) élastique qui est disposé entre les disques (25, 26), le corps (30) élastique présentant une gorge (31) sur son pourtour,
sachant que le talon d'encliquetage (23) est associé à une ouverture d'encliquetage (36) qui présente une partie de retenue (37) et une partie d'insertion (38), que le diamètre (D37) de la partie de retenue est inférieur aux diamètres (D25, D26) des deux disques (25, 26) et que le bord (39) de la partie de retenue (37) s'étend le long d'un arc de plus de 180 °C,
sachant que les ouvertures d'encliquetage (36) sont disposées à une distance radiale (R1, R2) par rapport à un centre de rotation (D) et sont orientées dans le même sens, sachant qu'à l'endroit de chaque ouverture d'encliquetage (36), le centre (M37) de la partie de retenue (37) et le centre (M38) de la partie d'insertion (38) sont disposés à une distance radiale (R1, R2) identique par rapport au centre de rotation (D).

2. Appareil chirurgical selon la revendication 1, **caractérisé en ce que** les deux disques (25, 26) sont reliés l'un à l'autre par une âme (28), disposée de façon concentrique avec eux, et forment un corps (29).

3. Appareil chirurgical selon l'une des revendications précédentes, **caractérisé en ce que** le boîtier (11) présente au moins un support (20) qui est disposé dans un espace interne (16) du boîtier (11) et est maintenu à une distance par rapport au fond (12),

4. Appareil chirurgical selon la revendication 3, **caractérisé en ce que** le support (20) est constitué d'une plaque support.

5. Appareil chirurgical selon l'une des revendications précédentes, **caractérisé en ce que** le corps (30) élastique est relié par matière aux disques (25, 26) et/ou à l'âme (28).

6. Appareil chirurgical selon l'une des revendications précédentes, **caractérisé en ce que** les disques (25, 26) et/ou l'âme (28) sont formés de métal.

7. Appareil chirurgical selon l'une des revendications précédentes, **caractérisé en ce que** les disques (25, 26) et la nervure (28) sont réalisés d'une seule pièce, sans soudure et à partir d'un matériau homogène.

8. Appareil chirurgical selon l'une des revendications précédentes, **caractérisé en ce que** les disques (25, 26) sont disposés de façon concentrique l'un avec l'autre et sont orientés parallèlement l'un à l'autre.

9. Appareil chirurgical selon l'une des revendications précédentes, **caractérisé en ce que** les deux disques (25, 26) présentent des diamètres (D25, D26) différents.

10. Appareil chirurgical selon l'une des revendications précédents, **caractérisé en ce que** la périphérie extérieure du corps (30) élastique est affleurante avec les disques (25, 26).

11. Appareil chirurgical selon la revendication 1, **caractérisé en ce que** le diamètre (D37) de la partie de retenue (37) correspond au diamètre (D32) du fond (32) de la gorge (31).

12. Appareil chirurgical selon la revendication 1, **caractérisé en ce que** la partie de retenue (37) présente une entrée (40) sur laquelle des saillies (41, 42) arrondies se font face et définissent entre elles une distance (W) qui est inférieure au diamètre (D32) du fond (32) de la gorge (31), mais qui est supérieure au diamètre de l'âme (28).

13. Appareil chirurgical selon la revendication 1, **caractérisé en ce que** l'évidement d'encliquetage (36) présente une partie d'insertion (38) qui est plus grande qu'au moins un des disques (25, 26).
